# EUROPEAN PATENT APPLICATION

(11) **EP 4 648 089 A1**
(43) Date of publication of application: **12.11.2025**
(21) Application number: 24817462.5
(22) Date of filing: 13.09.2024
(51) Int. Cl.: H01L 21/311, H01L 21/02, H01L 21/027, H01J 37/06

(54) **METHOD FOR FORMING THREE-DIMENSIONAL MICROSTRUCTURE BY USING ETCHING, AND ETCHING MASK USED THEREIN**

(30) Priority: 15.03.2024 KR 20240036486
(71) Applicant: Seoul National University R&DB Foundation, Seoul 08826 (KR)
(72) Inventor: KIM, Ji Woo, Seoul 07324 (KR); MOON, Dong Hoon, Seoul 08785 (KR); LEE, Gwan Hyoung, Seoul 05268 (KR)
(74) Representative: Dompatent Partnerschaft von Patent- und Rechtsanwälten mbB
(86) International application number: PCT/KR2024/013957
(87) International publication number: WO 2025/192807

(57) **Abstract**

Disclosed are a method of forming a 3-D microstructure using etching and an etch mask used in the method. Specifically, disclosed is a method capable of forming an elaborate and complicated 3-D microstructure by using a carbon-based thin film as an etch mask and modifying the carbon-based thin film during an etching process.

## Description

### BACKGROUND

### 1. Technical Field

The present disclosure relates to a method of forming a three-dimensional (3-D) structure using etching and an etch mask that is used in the method. This application claims priority under 35 U.S.C. §119(a) to Korean Patent Application No. 10-2024-0036486, filed in the Korean Intellectual Property Office on March 15, 2024, the entire contents of which are incorporated herein by reference.

### 2. Related Art

In the semiconductor industry field, as a high degree of integration is required, the need to form a finer pattern on a silicon- or germanium-based semiconductor material emerges. Such a need also emerges in fields in which a 3-D microstructure needs to be formed, such as a microscopic robot or a bio sensor. However, conventional techniques for forming the 3-D microstructure are complicated because only a lithography process is used, have a limit in implementing an elaborate 3-D microstructure, and require many process steps.

In order to implement the elaborate 3-D microstructure, a material that is used as a mask needs to have a high etch resistance ratio and also needs to be capable of having a fine pattern formed thereon, and requires excellent mechanical strength and chemical stability, and an etching process for the material needs to be accurately controlled.

### SUMMARY

Various embodiments are directed to providing a method capable of forming an elaborate 3-D microstructure by etching a substrate.

However, technical objects to be achieved by the present disclosure are not limited to the aforementioned object, and the other objects not described above may be evidently understood from the following description by those skilled in the art.

An embodiment of the present disclosure provides a method of forming a 3-D structure by etching a substrate, and provides a method of forming a 3-D structure, including forming a carbon-based thin film on the substrate, patterning the carbon-based thin film, primarily etching the substrate by using the patterned carbon-based thin film as an etch mask and using an etching gas including fluorine, modifying the patterned carbon-based thin film so that the carbon-based thin film on an undercut region that is formed by the primary etching is closely attached to a sidewall of the substrate that has been primarily etched, and secondarily etching the substrate by using the modified carbon-based thin film as an etch mask and using an etching gas including fluorine.

Another embodiment of the present disclosure provides an etch mask that is used in the method of forming a 3-D structure and that includes a patterned carbon-based thin film.

In the method of forming a 3-D structure according to an embodiment of the present disclosure, an elaborate and complicated 3-D structure can be formed by etching a substrate.

In the method of forming a 3-D structure according to an embodiment of the present disclosure, an omniphobic characteristic of a surface of a substrate can be improved by forming a re-entrant structure on the surface of the substrate.

In the method of forming a 3-D structure according to an embodiment of the present disclosure, an etched depth under the etch mask can be elaborately controlled.

Effects of the present disclosure are not limited to the aforementioned effects, and the other effects not described above may be evidently understood by those skilled in the art from the specification and the accompanying drawings.

### BRIEF DESCRIPTION OF THE DRAWINGS

FIG. 1 is a flowchart illustrating a method of forming a 3-D structure according to an embodiment of the present disclosure.
FIG. 2A diagramatically illustrates steps of the method of forming a 3-D structure according to an embodiment of the present disclosure.
FIG. 2B diagramatically illustrates steps of the method of forming a 3-D structure according to an embodiment of the present disclosure.
FIG. 3 is a diagram illustrating shapes of patterned graphene thin films in Embodiments 5 to 16 and SEM images of 3-D structures that are finally formed.
FIG. 4 is a diagram illustrating a Raman spectrum of the graphene thin film that was synthesized for 120 minutes through a chemical vapor deposition (CVD) method in Embodiment 1.
FIG. 5 is a diagram illustrating an AFM height image (a), BF-TEM image (b), SAED image (c), and DF-TEM image (d) of the graphene thin film that was synthesized for 120 minutes through the CVD method in Embodiment 1.
FIG. 6 illustrates SEM images of a substrate and a graphene thin film that were obtained in Reference Examples 1-1 and 1-2.
FIG. 7 illustrates SEM images of a substrate and a 1-layer or 4-layer graphene thin film in Reference Examples 2-1 to 2-4.
FIG. 8 illustrates SEM images at timing (a) at which primary etching was terminated, timing (b) at which the graphene thin film was modified so that the graphene thin film was closely attached to an etched sidewall of a substrate, and timing (c) at which secondary etching was terminated in the manufacturing process according to Embodiment 1.
FIG. 9 illustrates a SEM image of a substrate in which the 3-D structure obtained according to Embodiment 4 was formed.
FIG. 10 illustrates SEM images of the substrate in which the 3-D structures obtained according to Embodiments 1 to 3 were formed.
FIG. 11 is a photo that was photographed by dropping an aqueous ethanol solution having surface tension of 30 mN/m on a surface of a substrate in which the 3-D structure obtained according to Embodiment 4 was formed, which was treated by PFOTS(1H,1H,2H,2H-perfluorooctyltrichlorosilane).
FIG. 12 is a diagram illustrating contact angles measured with respect to a surface of a common Si substrate, which was not treated, a surface of the common Si substrate, which was treated by PFOTS, a surface of the substrate in which the 3-D structure obtained according to Embodiment 4 was formed, which was treated by PFOTS, and a surface of the substrate in which the structure obtained in Comparison Example 1 was formed, which was treated by PFOTS.
FIG. 13 is a diagram illustrating etching depths that were examined with respect to the substrate on which etching was performed in Reference Examples 3.

### DETAILED DESCRIPTION OF THE INVENTION

In the entire specification of the present disclosure, unless explicitly described to the contrary, when any part "includes (or comprises)" another component, it indicates the further inclusion of other components, not the exclusion of other components.

In the entire specification of the present disclosure, when it is described that one member is placed "on" the other member, this includes a case in which one member adjoins the other member and a case where a third member is interposed between the two members.

In the entire specification of the present disclosure, a unit "weight part" may mean the ratio of weight between components.

In the entire specification of the present disclosure, "A and/or B" means "A and B or A or B".

In the entire specification of the present disclosure, a "re-entrant structure" may mean a structure including a column part and a cover part that is disposed on the column part and that has a greater diameter than the column part.

An embodiment of the present disclosure provides a method of forming a three-dimensional (3-D) structure by etching a substrate, and provides a method of forming a 3-D structure, including a step of forming a carbon-based thin film on the substrate, a step of patterning the carbon-based thin film, a step of primarily etching the substrate by using the patterned carbon-based thin film as an etch mask and using an etching gas including fluorine, a step of modifying the patterned carbon-based thin film so that the carbon-based thin film on an undercut region that is formed by the primary etching is closely attached to a sidewall of the substrate that has been primarily etched, and a step of secondarily etching the substrate by using the modified carbon-based thin film as an etch mask and using an etching gas including fluorine.

In the method of forming a 3-D structure according to an embodiment of the present disclosure, an elaborate and complicated 3-D microstructure can be formed by etching a substrate.

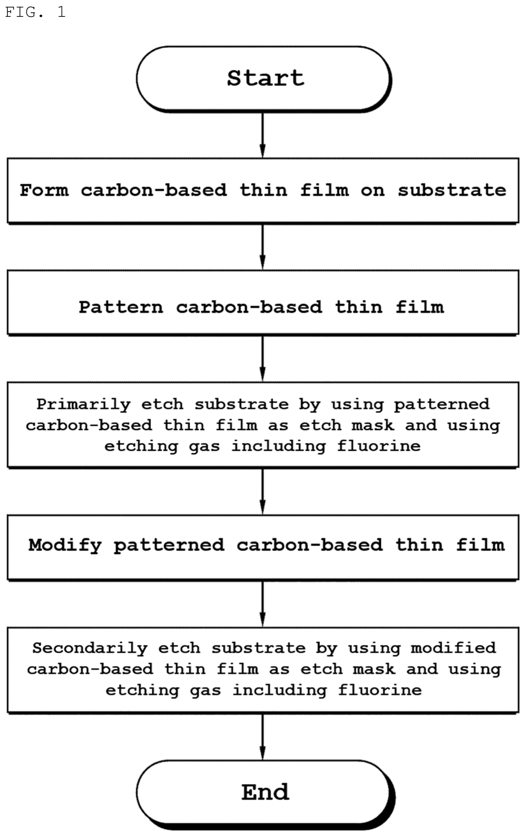

FIG. 1 is a flowchart illustrating a method of forming a 3-D structure according to an embodiment of the present disclosure.

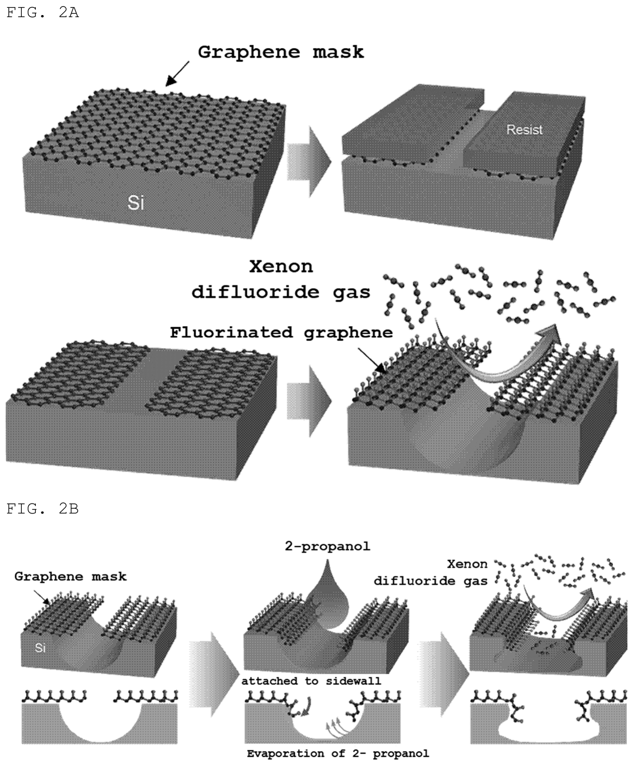

FIGS. 2A and 2B diagramatically illustrate steps of the method of forming a 3-D structure according to an embodiment of the present disclosure.

In the method of forming a 3-D structure according to an embodiment of the present disclosure, a 3-D structure which cannot be obtained by the existing etching method can be formed by performing a step of using a patterned carbon-based thin film as an etch mask and modifying the patterned carbon-based thin film.

According to an embodiment of the present disclosure, the 3-D structure may be a re-entrant structure. An omniphobic characteristic of a surface of the substrate can be improved because the re-entrant structure is formed by etching the substrate.

According to an embodiment of the present disclosure, the substrate may include silicon (Si), germanium (Ge), silicon germanium (SiGe), or a compound of them. If the substrate includes silicon (Si), germanium (Ge), silicon germanium (SiGe), or compounds, etching velocity by an etching gas including fluorine may be increased.

According to an embodiment of the present disclosure, a method of performing the step of forming the carbon-based thin film on the substrate is not specially limited, and may include transferring a carbon-based thin film that is obtained through mechanical peeling-off on a substrate or directly synthesizing the carbon-based thin film on the substrate by using a chemical vapor deposition (CVD) method or a sputtering method, for example.

According to an embodiment of the present disclosure, the step of forming the carbon-based thin film on the substrate may be performed by a CVD method or a sputtering method. If the carbon-based thin film is formed on the substrate by the CVD method or the sputtering method, the carbon-based thin film having a thin and uniform thickness can be obtained, and the thickness of the carbon-based thin film can be easily adjusted.

According to an embodiment of the present disclosure, the carbon-based thin film is a thin film including a carbon-based material, and may preferably include graphene or an amorphous carbon atom layer. The carbon-based thin film can completely cover a surface of an etching target substrate and the etching gas including fluorine can be prevented from penetrating into the substrate under the carbon-based thin film because the carbon-based thin film includes the graphene or the amorphous carbon atom layer.

According to an embodiment of the present disclosure, the thickness of the carbon-based thin film may be 0.3 nm to 50 nm. More specifically, the thickness of the carbon-based thin film may be 1 nm to 20 nm. The carbon-based thin film can be easily modified because the thickness of the carbon-based thin film satisfies the range of 0.3 nm to 50 nm.

According to an embodiment of the present disclosure, the step of patterning the carbon-based thin film may be performed by a step of forming a patterning layer on the carbon-based thin film by lithography; a step of forming the patterned carbon-based thin film through reactive ion etching (RIE) by using the patterning layer as an etch mask; and a step of removing the patterning layer. However, a method of patterning the carbon-based thin film is not limited thereto, and the carbon-based thin film may be patterned by another method that is known to those skilled in the art.

According to an embodiment of the present disclosure, the lithography may be photolithography or electron beam lithography. For example, the step of forming the patterning layer on the carbon-based thin film by photolithography may be performed by forming a photoresist material layer on the carbon-based thin film, radiating light by using a photo mask, and then developing a pattern by using a developer. The step of forming the patterning layer on the carbon-based thin film by electron beam lithography may be performed by forming an electron beam resist material layer on the carbon-based thin film, radiating an electron beam to a selected region, and then developing a pattern by using a developer. If the lithography is photolithography, a pattern of a 3-D structure may be formed with respect to a substrate having a large area.

According to an embodiment of the present disclosure, through the RIE, the same pattern as a pattern that is formed on the patterning layer may be patterned on the carbon-based thin film because the carbon-based thin film of a region that is not covered by the patterning layer is removed.

According to an embodiment of the present disclosure, the RIE may include using oxygen plasma and/or hydrogen plasma.

According to an embodiment of the present disclosure, the step of removing the patterning layer may be performed by using a solvent capable of selectively dissolving the material of the patterning layer.

According to an embodiment of the present disclosure, the patterned carbon-based thin film may have various pattern designs depending on a shape of a 3-D structure to be formed.

The patterned carbon-based thin film may include an opening, and may further include a plurality of fine holes according to an embodiment.

According to an embodiment of the present disclosure, if the patterned carbon-based thin film further includes the plurality of fine holes, the etching depth of the substrate under a region in which the plurality of fine holes is formed may be adjusted based on the size of the fine hole.

According to an embodiment of the present disclosure, the size of the fine hole may be 0.01 *µ*m to 10 *µ*m.

According to an embodiment of the present disclosure, the step of primarily etching the substrate and the step of secondarily etching the substrate may include etching the substrate through a chemical reaction between the etching gas including fluorine and the substrate without using plasma.

Damage to the substrate attributable to radicals and ions, which may occur in a plasma etching process, is prevented because the step of primarily etching the substrate and the step of secondarily etching the substrate includes etching the substrate through a chemical reaction between the etching gas including fluorine and the substrate. Accordingly, a more elaborate 3-D structure may be formed. Furthermore, selective etching for the substrate may be effective because the carbon-based thin film is not etched in the primary and secondary etching steps because the step of primarily etching the substrate and the step of secondarily etching the substrate includes etching the substrate through a chemical reaction between the etching gas including fluorine and the substrate.

According to an embodiment of the present disclosure, a fluorocarbon atom layer may be generated because a top surface of the carbon-based thin film that is exposed to the etching gas including fluorine becomes fluoride. The carbon-based thin film may have etching resistance that is close to infinity against the etching gas including fluorine because the fluorocarbon atom layer is formed on the top surface of the carbon-based thin film.

According to an embodiment of the present disclosure, the etching gas including fluorine may include at least one of xenon difluoride (XeF₂), carbon tetrafluoride (CF₄), and sulfur hexafluoride (SF₆). Preferably, the etching gas including fluorine may include xenon difluoride (XeF₂).

According to an embodiment of the present disclosure, the step of primarily etching the substrate and the step of secondarily etching the substrate by using the etching gas including fluorine may be isotropic etching.

An undercut region that is etched under the patterned carbon-based thin film may be formed by the primary etching because the step of primarily etching the substrate is isotropic etching.

The size of the undercut region that is formed by the primary etching can be adjusted by adjusting the execution time of the step of primarily etching the substrate. A relative ratio between the height of a column part and the thickness of a cover part in a formed 3-D re-entrant structure can be adjusted by adjusting the size of the undercut region. More specifically, if the execution time of the step of primarily etching the substrate is reduced, the size of the undercut region that is formed is reduced, and the thickness of the cover part in the formed 3-D re-entrant structure may be relatively reduced. A surface characteristic, for example, a contact angle of the substrate in which the 3-D re-entrant structure is formed may be changed by adjusting the relative ratio between the height of the column part and the thickness of the cover part in the 3-D re-entrant structure as described above.

According to an embodiment of the present disclosure, the execution time of each of the step of primarily etching the substrate and the step of secondarily etching the substrate may be adjusted in the range of 1 second to 60 minutes, but is not specially limited thereto.

According to an embodiment of the present disclosure, a structure that is finally formed may have a 3-D pattern in addition to a two-dimensional (2-D) pattern because the step of modifying the patterned carbon-based thin film is performed so that the carbon-based thin film on the undercut region that is formed by the primary etching is closely attached to the sidewall of the substrate that is primarily etched.

According to an embodiment of the present disclosure, the step of modifying the patterned carbon-based thin film may be performed by applying a volatile liquid on the patterned carbon-based thin film and evaporating the volatile liquid.

According to an embodiment of the present disclosure, the volatile liquid may be an organic compound having a low molecular weight. Specifically, the organic compound having a low molecular weight may be alcohol, ether, ketone, or ester, and may be alcohol, preferably. For example, the volatile liquid may include 2-propanol, ethanol, methanol, or a combination of them. If the volatile liquid is alcohol, it is proper to sufficiently wet a surface of the patterned carbon-based thin film because surface tension is small and alcohol is easily evaporated because alcohol has high volatility.

According to an embodiment of the present disclosure, a 3-D structure may be formed by performing the step of secondarily etching the substrate by using the modified carbon-based thin film as an etch mask and using the etching gas including fluorine.

Another embodiment of the present disclosure provides an etch mask that is used in the method of forming a 3-D structure and that includes a patterned carbon-based thin film.

The etch mask may be variously modified during an etching process based on a high elastic modulus, mechanical stability, and thin thickness of the patterned carbon-based thin film, and may enable elaborate etching because the etch mask has etching resistance that is close to infinity with respect to an etching gas including fluorine.

The method of forming a 3-D structure according to an embodiment of the present disclosure may further include a step of removing the modified carbon-based thin film after the step of secondarily etching the substrate.

Specifically, the modified carbon-based thin film may be removed by performing an RIE process by using a gas that does not include fluorine. For example, the modified carbon-based thin film may be removed by performing an RIE process by using oxygen plasma and/or hydrogen plasma.

Hereinafter, embodiments of the present disclosure are described in detail in order to specifically describe the present disclosure. However, embodiments according to the present disclosure may be modified in other various forms, and the scope of the present disclosure is not construed as being limited to the following embodiments. Embodiments of this specification are provided to a person having ordinary knowledge in the art to more completely describe the present disclosure.

### Embodiment 1

### (1) Step of forming graphene thin film on substrate

A silicon (Si) substrate (thickness: 550 to 550 µm, P-type boron doping, prime grade, Namgang Hi-Tech Co., Ltd.) was prepared as an etching target substrate. The graphene thin film was synthesized on the Si substrate by using a CVD method. Specifically, the Si substrate was disposed in a reaction chamber. After a temperature of the Si substrate was raised up to 1020°C at the rate of about 16.6°C/minute while supplying a hydrogen (H₂) gas, the graphene thin film having a thickness of about 1.5 to 2 nm was synthesized on the Si substrate by performing the synthesis for 120 minutes while supplying methane (CH₄) and hydrogen (H₂) gases.

### (2) Step of patterning graphene thin film

The patterning layer was formed on the graphene thin film electron beam by using lithography. Specifically, a polymethylmethacryate (PMMA) layer was formed on the graphene thin film by coating a PMMA solution (950 PMMA A6) on the graphene thin film. An electron beam was radiated to a PMMA layer by using an electric field emission type scanning electron microscope (MIRA3 XMH of TESCAN Inc.). Thereafter, a PMMA patterning layer was formed on the carbon-based thin film by dipping the PMMA layer into a 3:1 solution of 2-propanol and Di water as a developer for 1 minute.

The patterned graphene thin film was obtained by etching the graphene thin film for 3 minutes with power of 30 W while flowing a carbon tetrafluoride (CF₄) gas at a flow rate of 20 sccm by using the PMMA patterning layer as an etch gas and using a reactive ion etching apparatus (RIE-10NR of SAMCO Inc.). Thereafter, the PMMA patterning layer was removed by dipping a stack of the substrate-patterned graphene thin film-PMMA patterning layer into acetone for 10 minutes.

### (3) Step of primarily etching substrate by using patterned graphene thin film as etch mask and using etching gas including fluorine

A dry etching process using a xenon difluoride (XeF₂) gas was performed by using the patterned graphene thin film as an etch mask. The primary etching was performed at room temperature (about 20°C) at etching gas pressure (P_{XeF2}) = 3 torr for a treatment time (tₑₓₚₒₛᵤᵣₑ) of 220 seconds by using an XeF₂ etching apparatus (VPE-4F of SAMCO Co., Ltd.).

### (4) Step of modifying patterned graphene thin film

The graphene thin film that floated on the undercut formed by the primary etching was modified so that the graphene thin film was closely attached to the etched sidewall of the substrate by repeating a process of dropping 2-propanol on the patterned carbon-based thin film and then performing natural drying three times.

### (5) Step of secondarily etching substrate by using modified graphene thin film as etch mask and using etching gas including fluorine

The 3-D structure was formed by performing the secondary etching by using the same method as the step of primarily etching the substrate except that the treatment time was set to 50 seconds by using the modified graphene thin film as an etch mask as described above.

### Embodiment 2

### (1) Step of forming graphene thin film on substrate

The graphene thin film having a thickness of about 1.5 to 2 nm was synthesized on the Si substrate by using the same method as the method of Embodiment 1.

### (2) Step of patterning graphene thin film

In order to form the 3-D structure on the Si substrate having a large area, the patterning layer was formed on the graphene thin film by using photolithography. Specifically, after AZ5214E was coated on the graphene thin film at a thickness of 1 *µ*m as photoresist and a photolithograpy process was performed, the graphene thin film was dipped into an AZ 917 MIF developer for about 1 minute for development.

### (3) Step of primarily etching substrate by using patterned graphene thin film as etch mask and using etching gas including fluorine

The primary etching was performed by using the same method as the method of Embodiment 1 except that the treatment time (tₑₓₚₒₛᵤᵣₑ) was set to 180 seconds.

### (4) Step of modifying patterned graphene thin film

The graphene thin film that floated on the undercut formed by the primary etching was modified so that the graphene thin film was closely attached to the etched sidewall of the substrate by using the same method as the method of Embodiment 1.

### (5) Step of secondarily etching substrate by using modified graphene thin film as etch mask and using etching gas including fluorine

The 3-D structure was formed by performing the secondary etching by using the same method as the method of Embodiment 1.

### Embodiment 3

The 3-D structure was formed by using the same method as the method of Embodiment 2 except that the treatment time (tₑₓₚₒₛᵤᵣₑ) was set to 120 seconds in the step of primarily etching the substrate according to Embodiment 2.

### Embodiment 4

After the step of secondarily etching the substrate according to Embodiment 2, a step of removing the modified graphene thin film was further performed.

Specifically, the graphene thin film was removed by performing the RIE process for 2 minutes with power of 100 W while flowing oxygen at the flow rate of 20 sccm.

### Embodiments 5 to 16

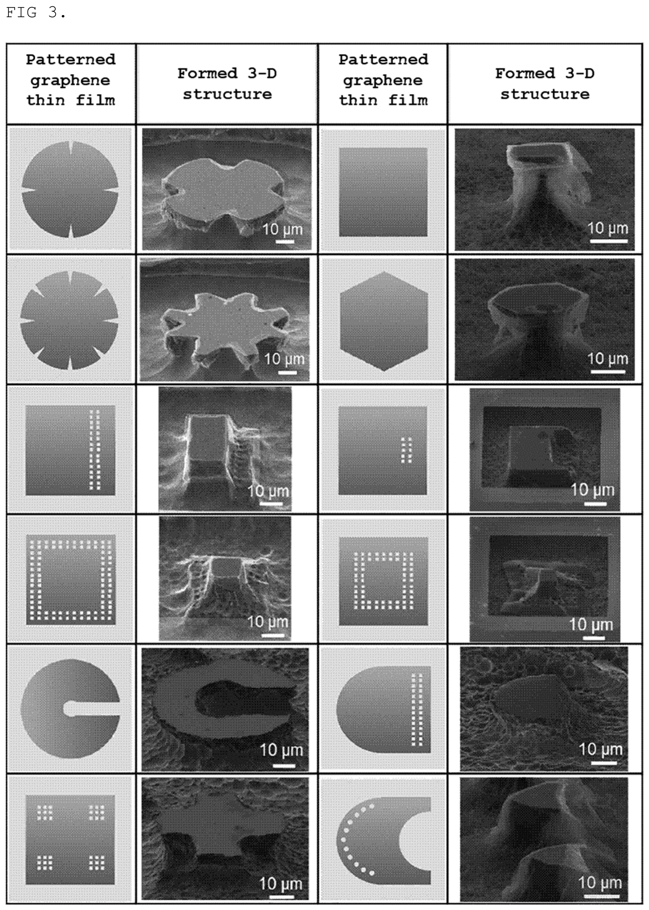

The 3-D structure was formed by using the same method as the method of Embodiment 1 except that the patterned graphene thin film was formed to have shapes, such as the shapes illustrated in FIG. 3, in the step of patterning the graphene thin film according to Embodiment 1.

SEM images of the 3-D structures according to Embodiments 5 to 16 were obtained by a scanning electronic microscope. FIG. 3 illustrates the shapes of the patterned graphene thin film according to Embodiments 5 to 16 and the SEM images of the 3-D structures that are finally formed. Referring to FIG. 3, it was found that the 3-D structure that was formed by the method according to an embodiment of the present disclosure can implement a complicated and elaborate 3-D structure.

### Comparison Example 1

A substrate in which a column structure was formed was obtained by omitting the step of modifying the patterned graphene thin film and the step of secondarily etching the substrate in Embodiment 1 and performing up to the step of primarily etching the substrate identically with those described in Embodiment 1.

### Reference Example 1-1 and Reference Example 1-2

After graphene thin films formed on a Si substrate were obtained by adjusting synthesis times to 30 minutes (Reference Example 1-1) and 6 hours (Reference Example 1-2), respectively, in the step of forming the graphene thin film on the Si substrate according to Embodiment 1, each of the graphene thin films was patterned by using the same method as the method of Embodiment 1, and primary etching was performed on each of the Si substrates using the patterned graphene thin film as an etch mask.

### Reference Examples 2-1 to 2-4

1-layer or 4-layer graphene was obtained by a mechanical peeling-off method using a scotch tape in the step of forming the graphene thin film on the Si substrate according to Embodiment 1. The 1-layer or 4-layer graphene thin film was transferred on each of the Si substrates. Thereafter, primary etching was performed on each of the Si substrates by using each of the transferred graphene thin films as an etch gas by using the same method as the method of Embodiment 1.

### Reference Example 3

The patterned graphene thin film in Embodiment 1 was formed to include a first pattern part including a plurality of fine holes each having a size of 0.6 µm, a second pattern part including a plurality of fine holes having a size of 1.4 µm, a third pattern part including a plurality of fine holes having a size of 2 µm, and a fourth pattern part including a plurality of fine holes having a size of 3.6 µm. The step of modifying the patterned graphene thin film and the step of secondarily etching the substrate were omitted, and only the step of primarily etching the substrate was performed identically with that described in Embodiment 1.

### <Experiment Example 1. Check of synthesized graphene thin film>

A Raman spectrum of the graphene thin film obtained in the step of forming the graphene thin film on the substrate according to Embodiment 1 was obtained by a 532 nm laser by using Raman spectrograph (LabRAM HR Evolution of Horiba Co., Ltd.).

Furthermore, an AFM image of the graphene thin film was obtained by using an atomic force microscope (AFM) (NX-10 of Park System Co.). A bright-field TEM (BF-TEM) image, selective area diffraction (SAED) image, and dark-field TEM (DF-TEM) image of the graphene thin film was obtained by using a cs-corrected monochromated TEM (Themis Z of Thermo Fisher Inc.) at an acceleration voltage of 80 kV.

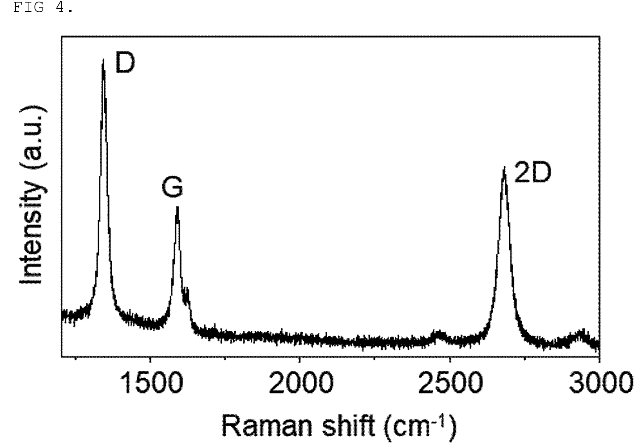

FIG. 4 is a diagram illustrating the Raman spectrum of the graphene thin film that was synthesized for 120 minutes through the CVD method in Embodiment 1.

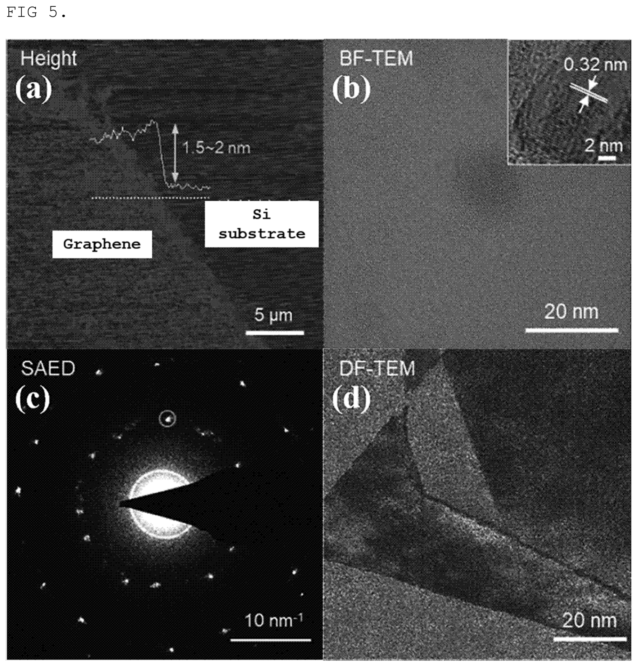

FIG. 5 is a diagram illustrating the AFM height image (a), BF-TEM image (b), SAED image (c), and DF-TEM image (d) of the graphene thin film that was synthesized for 120 minutes through the CVD method in Embodiment 1.

Referring to FIGS. 4 and 5, it was found that the graphene thin film having a thickness of approximately 1.5 to 2 nm was well formed as the results of the synthesis of graphene for 120 minutes through the CVD method in Embodiment 1.

SEM images of the substrates and the graphene thin films obtained in Reference Examples 1-1 to 1-2 and Reference Examples 2-1 to 2-4 were obtained by using a scanning electronic microscope.

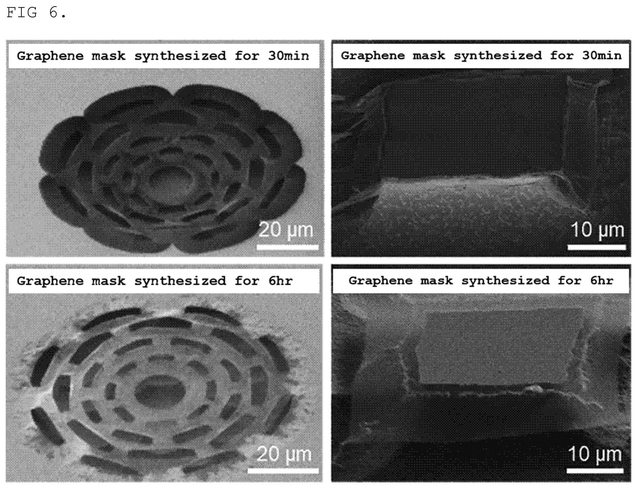

FIG. 6 illustrates the SEM images of the substrate and the graphene thin film obtained in Reference Examples 1-1 and 1-2. Referring to FIG. 6, it was found that the graphene thin film on the undercut region formed by the primary etching was downward bent and became close to a barrier rib even in the state in which a barrier rib adhesion step using a volatile liquid had not been performed because the graphene thin film synthesized for 30 minutes in Reference Example 1-1 had a thin thickness. In contrast, it was found that the graphene thin film on the undercut region maintained its shape without any change without being bent before the barrier rib adhesion step using a volatile liquid was performed because the graphene thin film synthesized for 6 hours in Reference Examples 1-2 had a relatively thick thickness.

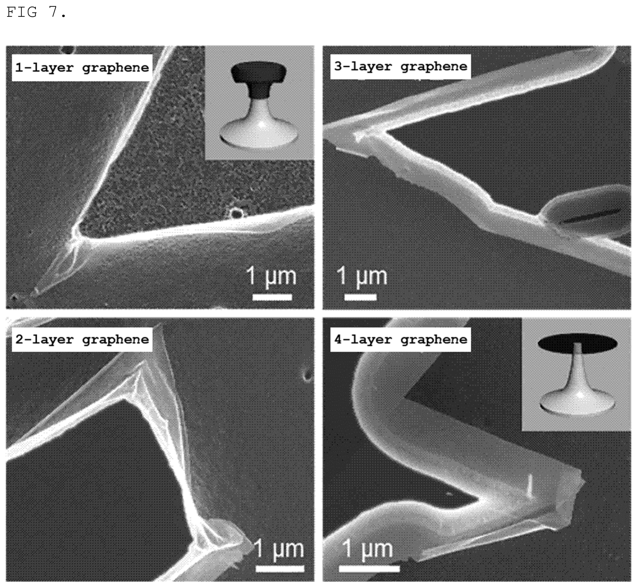

FIG. 7 illustrates SEM images of the substrate and the 1-layer or 4-layer graphene thin film in Reference Examples 2-1 to 2-4. Referring to FIG. 7, it was found that in the case of Reference Example 2-1 in which the 1-layer graphene thin film was used as an etch mask, the 1-layer graphene thin film was downward bent by gravity and became close to the barrier rib even in the state in which the barrier rib adhesion step using a volatile liquid had not been performed because the 1-layer graphene thin film was thin and had small stiffness. In contrast, it was found that in the case of Reference Example 2-4 in which the 4-layer graphene thin film was used as an etch mask, the 4-layer graphene thin film on the undercut region maintained its shape without any change without being bent before the barrier rib adhesion step using a volatile liquid was performed because the 4-layer graphene thin film had a relatively thick thickness.

### <Experiment Example 2. Check of changes according to primary etching and secondary etching>

SEM images were photographed at timing at the primary etching was terminated, timing at which the graphene thin film was modified so that the graphene thin film was closely attached to the etched sidewall of the substrate, and at timing at which the secondary etching was terminated in the manufacturing process according to Embodiment 1.

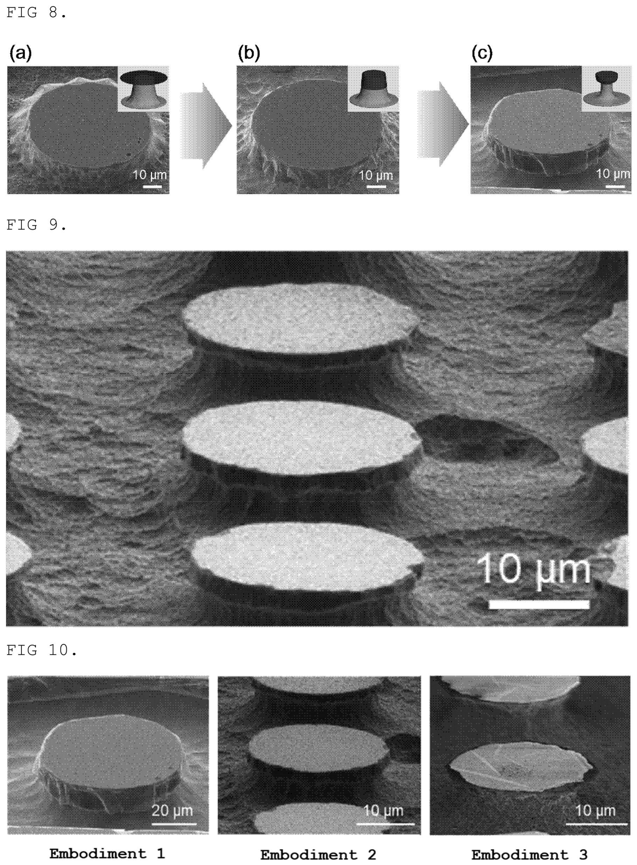

FIG. 8 illustrates the SEM images at the timing (a) at which the primary etching was terminated, the timing (b) at which the graphene thin film was modified so that the graphene thin film was closely attached to the etched sidewall of the substrate, and the timing (c) at which the secondary etching was terminated in the manufacturing process according to Embodiment 1. From FIG. 8, a form in which the undercut region was formed by the primary etching, the graphene thin film modified so that the graphene thin film was closely attached to the etched sidewall of the substrate, and the 3-D structure obtained through the secondary etching may be seen.

### <Experiment Example 3. Check of re-entrant structure>

In order to check shapes of the 3-D structures formed according to Embodiments 1 to 4, the 3-D structures formed by using a scanning electronic microscope (SEM) were photographed.

FIG. 9 illustrates a SEM image of the substrate in which the 3-D structure obtained according to Embodiment 4 was formed. Referring to FIG. 9, it was found that the 3-D structure formed according to Embodiment 4 was a re-entrant structure and a 3-D re-entrant structure pattern having a large area was formed on the substrate.

FIG. 10 illustrates SEM images of the substrate in which the 3-D structures obtained according to Embodiments 1 to 3 were formed. Referring to FIG. 10, it was found that as the execution time (i.e., the treatment time) of the step of primarily etching the substrate was reduced, the undercut region formed by the primary etching was reduced, and the thickness of the cover part of the re-entrant structure that was finally formed was relatively reduced.

### <Experiment Example 4. Check change in characteristics of contact angle>

In order to check an omniphobic characteristic of a surface of the substrate due to the forming of the 3-D re-entrant structure, that is, a change in water repellency and oil repellency characteristics, a contact angle of the surface of the substrate for an aqueous ethanol solution was measured. Specifically, the contact angles of a surface of a substrate that was obtained by treating a surface of the substrate in which the 3-D re-entrant structure obtained according to Embodiment 4 was formed by PFOTS (1H,1H,2H,2H-perfluorooctyltrichlorosilane), a surface of a substrate that was obtained by treating a surface of the substrate in which the column structure obtained according to Comparison Example 1 was formed by PFOTS, a surface of the common Si substrate (thickness: 550 to 550 *µ*m, P-type boron doping, prime grade, Namgang Hi-Tech Co., Ltd.) that was not etched as a comparison group and treated by PFOTS, and a surface of the common Si substrate (thickness: 550 to 550 *µ*m, P-type boron doping, prime grade, Namgang Hi-Tech Co., Ltd.) that was not etched as a comparison group and was treated by PFOTS were measured. The measurement of the contact angles of the surfaces of the substrates was performed through contact angle measurement equipment (Model 250 of Rame-Hart Inc.) by mixing ethanol and water, dropping the mixture of ethanol and water on the surface-treated surface or the surface-not-treated surface by using an aqueous ethanol solution having adjusted surface tension as PFOTS.

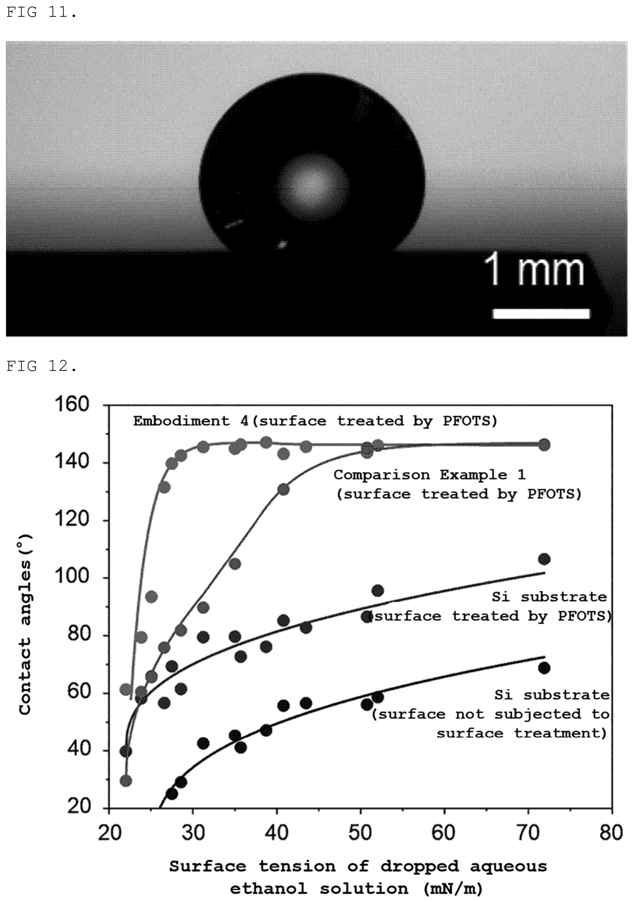

FIG. 11 is a photo that was photographed by dropping the aqueous ethanol solution having surface tension of 30 mN/m on the surface of the substrate in which the 3-D structure obtained according to Embodiment 4 was formed, which was treated by PFOTS.

FIG. 12 is a diagram illustrating contact angles measured with respect to a surface of a common Si substrate, which was not treated, a surface of the common Si substrate, which was treated by PFOTS, a surface of the substrate in which the 3-D structure obtained according to Embodiment 4 was formed, which was treated by PFOTS, and a surface of the substrate in which the structure obtained in Comparison Example 1 was formed, which was treated by PFOTS.

Referring to FIGS. 11 and 12, the surface of the substrate in which the re-entrant structure obtained according to Embodiment 4 was formed has a significantly higher contact angle than the surface of the common Si substrate, which was not treated, and the surface of the common Si substrate, which was treated by PFOTS. Moreover, the contact angle of the surface on which the re-entrant structure obtained according to Embodiment 4 was formed is significantly higher than that of the surface of the substrate, which was treated by PFOTS, in Comparison Example 1 in which a common column structure by isotropic etching not the re-entrant structure was formed. It was found that a water-repellent characteristic of the substrate is improved due to the forming of the re-entrant structure.

### <Experiment Example 5. Adjustment of etching depth according to size of fine hole>

The etched depths of a lower substrate corresponding to the first pattern part, the second pattern part, the third pattern part, and the fourth pattern part were examined by using a surface depth profiler (DektakXT-A of Bruker Co.) with respect to the substrate obtained by performing the primary etching in Reference Examples 3.

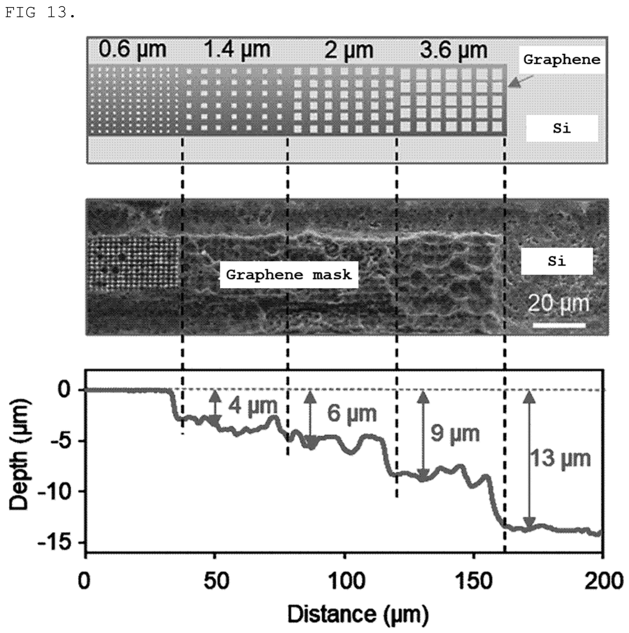

FIG. 13 is a diagram illustrating etching depths that were examined with respect to the substrate on which etching was performed in Reference Examples 3. Referring to FIG. 13, it was found that the etching depth of a corresponding pattern part was adjusted based on the size of the fine hole formed in the patterned graphene thin film and a 3-D structure having an etching depth adjusted in five stages can be formed by performing etching by using the patterned graphene thin film including the first to fourth pattern parts.

Although the present disclosure has been described above in connection with the limited embodiments and drawings, the present disclosure is not limited to the embodiments. A person having ordinary knowledge in the art to which the present disclosure pertains may modify and change the present disclosure within the technical spirit of the present disclosure and the equivalent range of the following claims.

## Claims

1. A method of forming a three-dimensional (3-D) structure by etching a substrate, the method comprising steps of:
forming a carbon-based thin film on the substrate;
patterning the carbon-based thin film;
primarily etching the substrate by using the patterned carbon-based thin film as an etch mask and using an etching gas comprising fluorine;
modifying the patterned carbon-based thin film so that the carbon-based thin film on an undercut region that is formed by the primary etching is closely attached to a sidewall of the substrate that has been primarily etched; and
secondarily etching the substrate by using the modified carbon-based thin film as an etch mask and using an etching gas comprising fluorine.

2. The method of claim 1, wherein the step of patterning the carbon-based thin film comprises steps of:
forming a patterning layer on the carbon-based thin film by lithography;
forming the patterned carbon-based thin film through reactive ion etching (RIE) by using the patterning layer as an etch mask; and
removing the patterning layer.

3. The method of claim 1, wherein the step of modifying the patterned carbon-based thin film is performed by applying a volatile liquid on the patterned carbon-based thin film and evaporating the volatile liquid.

4. The method of claim 1, wherein the substrate comprises silicon (Si), germanium (Ge), silicon germanium (SiGe), or a compound of them.

5. The method of claim 1, wherein the etching gas comprising fluorine comprises at least one of xenon difluoride (XeF₂), carbon tetrafluoride (CF₄), and sulfur hexafluoride (SF₆).

6. The method of claim 1, wherein the 3-D structure is a re-entrant structure.

7. The method of claim 1, wherein a thickness of the carbon-based thin film is 0.3 nm to 50 nm.

8. The method of claim 1, wherein the carbon-based thin film comprises graphene or an amorphous carbon atom layer.

9. The method of claim 1, further comprising a step of removing the modified carbon-based thin film after the step of secondarily etching the substrate.

10. The method of claim 1, wherein the patterned carbon-based thin film further comprises a plurality of fine holes.

11. The method of claim 1, wherein the step of primarily etching the substrate and the step of secondarily etching the substrate comprise etching the substrate through a chemical reaction between an etching gas comprising fluorine and the substrate without using plasma.

12. An etch mask that is used in the method of forming a 3-D structure according to claim 1 and that comprises a patterned carbon-based thin film.
